# EUROPÄISCHE PATENTSCHRIFT

(11) **EP 1 816 440 B1**
(45) Veröffentlichungstag und Bekanntmachung des Hinweises auf die Patenterteilung: **13.08.2008**
(21) Anmeldenummer: 07002255.3
(22) Anmeldetag: 02.02.2007
(51) Int. Cl.: G01D 5/14, H01L 27/22

(54) **Elektronische Baugruppe**
Electronic assembly
Agencement électronique

(30) Priorität: 07.02.2006 DE 102006005746
(43) Veröffentlichungstag der Anmeldung: 08.08.2007
(73) Patentinhaber: ELBAU Elektronik Bauelemente GmbH Berlin, 13088 Berlin (DE); Lenord, Bauer & Co. GmbH, 46145 Oberhausen (DE)
(72) Erfinder: Danowski, Marcus, 45966 Gladbeck (DE); Schmidt, Roman, 15537 Erkner (DE); Sichting, Thomas, 16567 Mühlenbeck (DE); Stritzke, Burghard, 45896 Gelsenkirchen (DE)
(74) Vertreter: Kassner, Klaus

(56) Entgegenhaltungen:
- EP-A2- 0 863 406
- WO-A-03/085736
- WO-A-20/05036644
- GB-A- 2 293 918

## Beschreibung

### Technisches Gebiet

Die Erfindung betrifft allgemein eine **elektronische Baugruppe** Insbesondere betrifft die Erfindung **eine Sensorbaugruppe, vorzugsweise eine magneto-resistive Sensorbaugruppe für Positions-und Winkelmesssysteme.** Derartige **Baugruppen** können z. B. unter Nutzung des magneto-resistiven Effektes auch als Inkremetal- oder Absolutgeber zur Erfassung einer Drehzahl, eines Winkels, einer Position oder eines Weges eines bewegten Bauteils, wie z.B. einer Welle, verwendet werden.

### Stand der Technik

Allgemein ist es in der Halbleitertechnik bekannt, elektronisch zu kontaktiernde Bauteile **von elektronischen Baugruppen** in so genannter Planartechnik herzustellen.

Es wurde schon nach einem internen Stand der Technik ein Verfahren zur Erfassung einer absoluten Winkelposition eines rotierenden Bauteils, insbesondere einer Welle, bekannt, bei dem in einer ersten ortsfesten Einheit, welche eine Auswerteelektronik aufweist, mindestens zwei unabhängige magneto-resistive Sensorpaare durch mindestens eine Magnetfeldquelle vormagnetisiert werden. Die Sensorpaare sind in unmittelbarer Nähe der Magnetfeldquelle angeordnet. In einer zweiten mit diesem Bauteil rotierenden Einheit überdeckt mindestens ein Modulator, der stellungsabhängig den magnetischen Fluss der Magnetfeldquelle am Ort der Sensorpaare in Dichte und/oder Richtung verändert, infolge seiner Rotation mit dem Bauteil die Sensoren periodisch und beeinflusst deren Erregung. Dabei sind die Sensoren je eines Sensorpaars so angeordnet, dass sie durch die Überdeckungselemente des Modulators mit einem Winkelunterschied von einem Viertel der Überdeckungsperiode überdeckt werden.

Ein derartiges Verfahren kennzeichnet sich gemäß der Anmeldung AZ DE 103 40 065.6 durch eine Überdeckung unterschiedlicher Sensorpaare mit einer voneinander abweichenden Überdeckungsperiodenlänge bei Rotation des Bauteils und Bestimmung des absoluten Winkels durch Vergleich der Erregungsstärke verschiedener Sensorpaare und Sensoren je eines Sensorpaars untereinander, wobei die Sensoren **magneto-resistive** Sensoren, bevorzugt **giant- magneto-resistive** Sensoren, sind.

Dieses Verfahren ist durch
- einen zumindest teilweise aus ferromagnetischem Material bestehenden Modulator,
- einen Abstand der magneto-resistiven Sensoren von dem mindestens einen Modulator bei gewählter magnetischer Flussdichte der mindestens einen Magnetfeldquelle, der so bemessen wird, dass der magnetfeldempfindliche Teil der magneto-resistiven Sensoren so positioniert ist, dass dieser von den Dichte- und Richtungsänderungen des magnetischen Flusses bei Rotation des Modulators unbeeintlusst bleibt, die in Folge des diskontinuierlichen Übergangs von Luft zu ferromagnetischem Material in der unmittelbaren Nähe der Oberfläche des mindestens einen Modulators unerwünschte unharmonische Komponenten aufweisen,
ausbaufähig.

Zur Durchführung dieses Verfahrens wurde zugleich ein entsprechender Winkelgeber vorgeschlagen, der als Sensoren besagte **magneto-resistive** Sensoren umfasst.

Dieser Winkelgeber ist so gestaltet, dass
- die mindestens eine Magnetfeldquelle aus einem Permanentmagneten und/oder Elektromagneten, bevorzugt aus einer schräg magnetisierten Permanentmagnetfolie, besteht,
- das Magnetfeld gegenüber den Sensoroberflächen parallel zur Normale der Ebene jedes einzelne Sensors ausgebildet ist,
- der mindestens eine Magnet ein AINICo-, Sinter- oder Seltenerdenmagnet ist,
- die unmodulierte Magnetfeldstärke am Ort eines Sensors 1 mT bis 600 mT, bevorzugt ungefähr 300 mT beträgt,
- die Sensoren direkt auf der mindestens einen Magnetfeldquelle angeordnet sind,
- die Normale der Sensoroberfläche senkrecht zur Rotationsachse des mindestens einen Modulators ausgerichtet ist,
- die Sensoren in einem Bereich von 100 µm bis 5 mm, bevorzugt 300 µm bis 500 µm entfernt von dem mindestens einen Modulator angeordnet sind,
- mindestens ein Zahnrad für ein inkremental arbeitendes Messsystem vorgesehen ist und mindestens zwei Zahnräder einer unterschiedlichen Anzahl Zähne für ein absolut arbeitendes Messsystem vorgesehen sind, die bevorzugt paarweise einen Unterschied von einem Zahn aufweisen,
- mindestens eine Zahnstange für ein inkremental arbeitendes Meßsystem vorgesehen ist und mindestens zwei Zahnstangen einer unterschiedlichen Anzahl Zähne für ein absolut arbeitendes Messsystem vorgesehen sind, das jeweils einen Weg oder eine Position eines Teils in einem Längenmesssystem misst,
- der mindestens eine Modulator zur Achse des zu erfassenden Winkels aus mindestens einer koaxial angeordneten ferromagnetischen Scheibe besteht, welche radiale Schlitze, Vertiefungen oder Erhöhungen aufweist und
- mindestens eine koaxial angeordnete ferromagnetische Scheibe vorgesehen ist und mindestens zwei konzentrische koaxial angeordnete Ringe vorgesehen sind, die aus äquidistant angeordneten Schlitzen, Vertiefungen oder Erhöhungen bestehen.

Mit diesem vorbeschriebenen System von Verfahren und Winkelgeber auf der Basis von **magneto-resistiven** Sensoren wurden bereits durch numerische Berechnungen zur Simulation des Magnetkreises, Untersuchungen zur Sensoranordnung sowie zu den zu verwendenden Materialien und Fertigungstechnologien die Grundlage für die mikrotechnische Realisierung für industrielle Anwendungen geschaffen.

Üblicherweise besitzen die in Halbleitertechnik hergestellten **magneto-resistiven** Sensoren magneto-resistive Strukturen, die in der eingangs erwähnten Planartechnik ausgeführt sind. Diese Strukturen haben ihre magneto-resistive Sensitivität nur bei Magnetfeldkomponenten, die parallel zur Fläche der Planarstrukturen verlaufen.

Um diese Wirkungsweise gezielt zu nutzen, gibt es prinzipiell die Möglichkeit, das Magnetfeld schräg zur sensitiven Oberfläche der **magneto-resistiven** Sensoren verlaufen zu lassen, etwa durch Wahl der Magnetisierungsrichtung des Permanentmagneten.

Diese Schrägfeld-Magnetisierungsrichtung hat jedoch die Nachteile, daß
- eine Unsymmetrie des Sensorsignals zwischen den verschiedenen Laufrichtungen des bewegten Bauteils sich in einem Signaloffset in Abhängigkeit zur Größe des Bauteils äußert,
- eine geringe Sättigungsfeldstärke sich aus dem geringen Feldstärkeanteil entlang der Fläche der magneto-resistiven Planarstrukturen ergibt und somit
- ein großer Einfluss durch die Remanenz des bewegten Bauteils bei höheren Geschwindigkeiten wirksam wird.

Gemäß der DE 103 34 634 B3 wird als Beispiel der Planartechnik ein Halbleiterchips offenbart, der seitliche Kontaktflächen aufweist. Dabei wird durch diese beschriebene Technik eine Verbindung zwischen zwei Halbleiterchips hergestellt, die jedoch bei der Anwendung zur Erfassung einer Drehzahl, eines Winkel, einer Position oder eines Weges eines bewegten Bauteils, wie z.B. einer Welle, mit den zuvor analysierten Nachteilen behaftet ist.

Die Analyse des Standes Technik zeigt naheliegend keinen Weg, bei vertretbarem Aufwand einen zuverlässigen Drahtbondkontakt auf einer geschnittenen bzw. anders strukturierten Kante eines keramischen Schaltungsträgers zu ermöglichen.

### Darstellung der Erfindung

Die Erfindung stellt sich die Aufgabe, den Aufbau eines elektronisch zu kontaktiernden Bauteils nicht nach herkömmlicher Planartechnik anzuordnen.

**Dabei ist** der Aufbau **einer elektronischen Baugruppe, insbesondere Sensorbaugruppe, vorzugsweise magneto-resistiven Sensorbaugruppe für Positions und Winkelmesssysteme zu ermöglichen und** entsprechend der vorgegebenen Richtung des Permanentmagnetfelds **anzuordnen.**

Die Erfindung soll mittels neuartiger Kombination von Mikromontagetechnologien den Aufbau **einer elektronischen Baugruppe,** die Justierung und Montage dersselben auf einen Basisträger ermöglichen. Die Anforderungen einer Temperaturbeständigkeit von ≤ 150° C bei kritischen Umgebungsbedingungen, wie Feuchte, Staub, Ölnebel, Vibrationen, Schockbelastungen sind mittels der erfindungsgemässen Anordnung zu erfüllen, wobei verbesserte Effekte hinsichtlich der Messung auch bei Schockbelastungen und hohen Einsatztemperaturen zu gewährleisten sind.

Es besteht darüber hinaus zur Erreichung hochempfindlicher Meßcharakteristiken das Ziel, dazu geeignete Aufbau- und Montagetechnologien zur Fertigung der Komponente **magneto-resistiver** Sensor zu schaffen, der in seinem Aufbau und seinen Verbindungen einen extrem kleinen Abstand zum Meßobjekt aufweist, wobei allgemein sich bewegende und nicht nur rotieren de Bauteile in ihrer Position mit einer extrem hohen Auflösung zu erfassen sind.

Erfindungsgemäß wird dies mit den Merkmalen der Ansprüche 1 bis 7 gelöst.

**Demzufolge wird eine elektronisch Baugruppe, insbesondere Sensorbaugruppe, vorzugsweise magneto-resistive Sensorbaugruppe für Positions- und Winkelmesssysteme, aufweisend einen Träger, auf dem ein kontaktiertes elektronisches Bauteil mit ersten elektrischen Anschlüssen angeordnet ist, sowie am Träger vorgesehene zweite und dritte elektrische Anschlüsse vorgeschlagen, bei der erfindungsgemäß**
**a) das kontaktierte elektronische Bauteil mit einer Fläche des Trägers verbunden ist und als erste elektrische Anschlüsse Anschlusspads auf einer senkrecht zu der Fläche des Trägers stehenden Seite des elektronischen Bauteils aufweist,**
**b) eine erste Stirnseite des Trägers in Dickschichttechnik strukturierte Kantenmetallisierungen für Drahtbondpads als zweite elektrische Anschlüsse aufweist,**
**c) die erste Stirnseite des Trägers mittels Waferschnitttechnik kammartig gesägt ist,**
**d) die Drahtbondpads auf der ersten Stirnseite des Trägers über Dickschichtstrukturen mit externen Anschlüssen an zweiten Stirnseiten als dritte elektrische Anschlüsse der elektronischen Baugruppe elektrisch leitend verbunden sind und**
**e) die i einer Ebene zur Stirnseite des Trägers liegenden Anschlusspads des elektronischen Bauteils mittels Drahtbonds mit den Drahtbondpads des elektrisch verbunden sind.**

Vorteilhaft die **elektronische Baugruppe** ein Sensor und die elektronische Baugruppe eine Sensorbaugruppe.

**Diese erfindungsgemässe elektronische Baugruppe wird so ausgestaltet, daß**
**a) die eine inkrementale oder absolute Position eines bewegten Bauteils erfassende magneto-resistive Sensorbaugruppe einen Basisträger, einen Verguss, mindestens eine elektronische Baugruppe und Drahtbonds zwischen elektronischem Bauteil (Sensor) und Träger aufweist,**
**b) die Drahtbonds ausserhalb des Bereichs des Abstands zum bewegten Bauteil und zwischen den Seitenflächen des senkrecht angeordneten elektronischem Bauteils und der ersten Stirnseite des Trägers liegen,**
**c) ein auf dem Basisträger oder Träger angeordneter Abstandskörper vorgesehen ist, der sowohl einen Höhenanschlag für die Optimierung des Abstands zwischen der zum bewegten Bauteil weisenden Oberseite des elektronischem Bauteils und der ebenfalls zum bewegten Bauteil weisenden Oberseite eines Gehäuses als auch ein Mittel im Hinblick auf Montagetoleranzen darstellt und**
**d) auf der Rückseite des Basisträgers ein Permanentmagnet angeordnet ist.**

Zweckmässig ist in **weiterer** Ausbildung der Erfindung **bei einem** auf die Seite gekippten Sensor auf den **T**räger mittels Klebetechnik befestigt.

Die den **T**räger und Sensor umfassende **elektronische B**augruppe kann als diskretes Bauteil auf dem Basisträger mittels
- Klebetechnik,
- Leitkleberkontaktierung,
- Drahtbondverbindung oder
- Lottechnik
befestigt werden.

Es kann auch eine weitere **elektronische B**augruppe, geometrisch definiert zur ersten Sensorbaugruppe, auf dem **T**räger angeordnet werden.

Die Gesamtheit **der Anordnung einer** erfindungsgemässen **elektronischen Baugruppe** mit den zuvor offenbarten Merkmalen wird durch einen Treiberträger, elektrisch verbunden über Verbindungskontakte mit dem Basisträger, komplettiert.

Der Vorteil der Erfindung besteht nun darin, daß das zu kontaktierende Bauteil wie Sensor durch ein Kippen um 90° die eingangs beschriebenen Nachteile ausräumt.

Speziell ein **magneto-resistiver** Sensor kann dadurch derart im Magnetfeld des Permanentmagneten angeordnet werden, dass die Magnetfeldkomponenten in Sensierrichtung genau parallel zur Fläche der magnetosresistiven Strukturen verlaufen.

Die Erfindung wird an Beispielen des Aufbaus und der Montage einers erfindungsgemäßen **magneto-resistiven Sensorbaugruppe** näher erläutert.

### Kurze Beschreibung der Zeichnungen

In den Zeichnungen zeigen
- Fig. 1: die Explosionsdarstellung einers erfindungsgemäßen **magneto-resistiven Sensorbaugruppe** (1),
- Fig. 2: eine erfindungsgemäße **elektronische Baugruppe** (5) und
- Fig. 3: eine Einbauvariante der **magneto-resistiven Sensorbaugruppe** (1).

### Bester Weg ur Ausführung der Erfindung

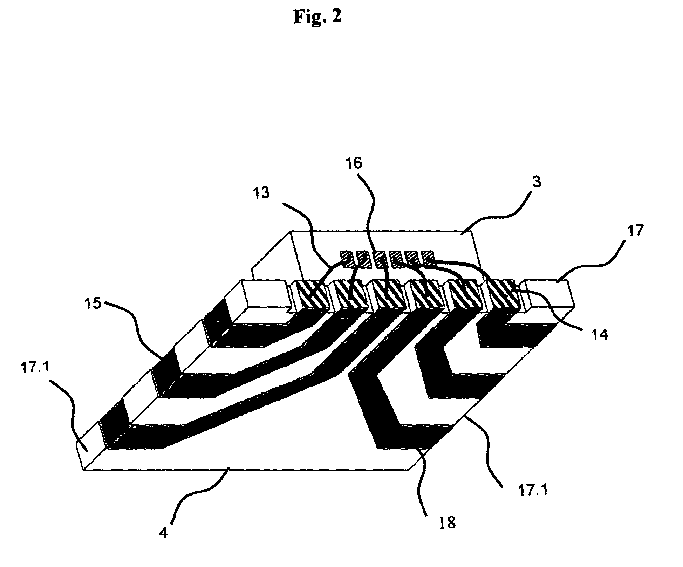

Allgemein ist die Erfindung in der Fig. 2 dargestellt, wonach die Anordnung eines an ersten Anschlüssen **wie Anschlußpads** 16 kontaktiertes elektronischen Bauteils 3 auf einem Träger 4 **mit zweiten und dritten** elektrischen Anschlüssen, **wie Drahtbondpads 14 und externe Anschlüsse** 15 zu einer elektronischen Baugruppe 5 gefügt ist, bei der
**a) das kontaktierte elektronische Bauteil 3 mit einer Fläche des Trägers 4 verbunden ist und als erste elektrische Anschlüsse die Anschlusspads 16 auf einer senkrecht zu der Fläche des Trägers 4 stehenden Seite des elektronischen Bauteils 3 aufweist,**
**b) eine erste Stirnseite 17 des Trägers 4 in Dickschichttechnik strukturierte Kantenmetallisierungen für die Drahtbondpads 14 als zweite elektrische Anschlüsse aufweist,**
**c) die erste Stirnseite des Trägers 4 mittels Waferschnitttechnik kammartig gesägt ist,**
**d) die Drahtbondpads 14 auf der ersten Stirnseite 17 des Trägers 4 über Dicknchichtstrukturen 18 mit den externen Anschlüssen15 an zweiten Stirnseiten 17.1 als dritte elektrische Anschlüsse der elektronischen Baugruppe 5 elektrisch leitend verbunden sind und**
**e) die einer Ebene zur Stirnseite des Trägers 4 parallel versetzt liegenden Anschlusspads 16 des elektronischen Bauteils 3 mittels Drahtbonds 13 mit den Drahtbondpads 14 des Trägers 4 elektrisch verbunden sind.**

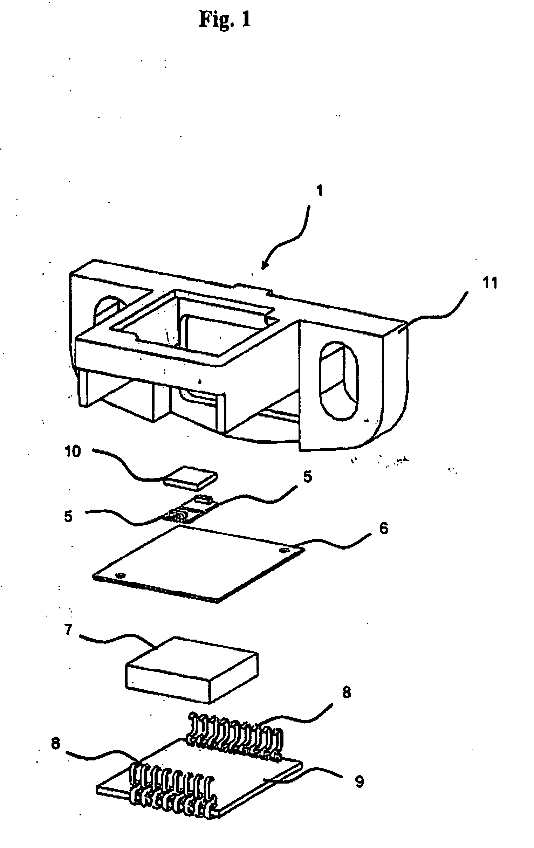

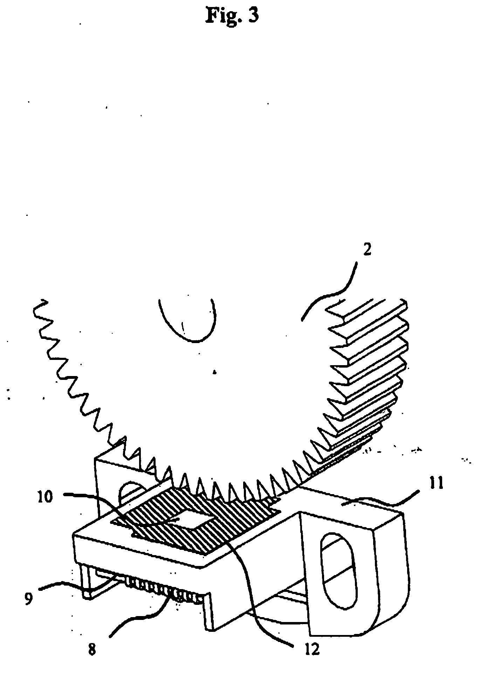

Gemäß der auch eine **elektronische B**augruppe 5 zeigenden Fig. 2, insbesondere für eine **magheto-resistive Sensorbaugruppe** 1 wie nach Fig.1 zusammengesetzt und nach Fig. 3 angewendet, besitzt ein keramischer Schaltungsträger möglichst geringer Dicke wie Träger 4 auf der ersten Stirnseite 17 die in Dickschichtstrukturen 18 ausgeführten Kantenmetallisierungcn, die als Drahtbondpads 14 dienen.

Um die erforderliche Haftfestigkeit der Drahtbondpads 14 zu erzielen, wird die mit den Kantenmetallisierungen zu bedruckende **erste** Stirnseite 17 des **T**rägers 4 mittels so genannter Waferschnitttechnik gesägt.

In der Dickschichttechnik werden keramische Schaltungsträger üblicherweise mittels Laserschnitttechnik strukturiert. Hierbei handelt es sich um einen thermischen Trennprozess, was zu einer Verglasung der geschnittenen Kanten führt. Die dabei entstehende glatte Oberfläche de Kanten ist hinsichtlich der Haftfestigkeit der Dickschichtstrukturen für die Drahtbondtechnik unzureichend.

Von den Drahtbondpads 14 auf der **ersten** Stirnseite 17 des **T**rägers 4 ausgehend, werden in Dickschichttechnik die externen Anschlüsse 15 **auf der zweiten stirnseite 17.1** strukturiert.

Auf der Seite des **T**rägers 4, die zu dem in Fig. 3 dargestellten bewegten Bauteil 2 zeigt, wird **das** auf die Seite gekippte, d. h. senkrecht gestellte **elektronische Bauteil** 3 **(wie magneto-resistiver Sensor)** mittels Klebtechnik montiert.

Die somit in einer Ebene zur **ersten** Stirnseite 17 des Sensorträgers **4 gemäß** **Fig. 2** **parallel versetzt** liegenden Anschlusspads 16 werden mittels Drahtbonds 13 mit den Drahtbondpads 14 des Sensorträgers 14 elektrisch verbunden.

Die **elektronische B**augruppe 5 besteht deshalb aus **dem kontaktierten elektronischen Bauteil** 3 und **T**räger 4, die in beschriebener Weise elektrisch verbunden sind. Diese wird entsprechend der Darstellung in Fig. 1 als diskretes Bauteil auf einem weiteren, vorzugsweise keramischen Schaltungsträger möglichst geringer Dicke - im Folgenden Basisträgcr 6 genannt - mittels Klebtechnik befestigt und über die Verbindungstechniken
a) Leitkleberkontaktierung,
b) Drahtbondverbindung oder
c) Löttechnik
   elektrisch verbunden.

Eine weitere **elektronische B**augruppe 5 kann, etwa zur Gewinnung eines Referenzsensorsignals, geometrisch definiert zur erstgenannten auf dem Basisträger 6 befestigt und mittels genannter Verbindungstechniken elektrisch verbunden werden.

Auf dem Basisträger 6 oder auf dem **T**räger 4 kann ein vorzugsweise keramischer Körper definierter Dicke - im Folgenden Abstandskörper 10, siehe auch Fig. 3, genannt - mittels bekannter Fügetechniken befestigt werden.

Auf der Rückseite des Basisträgers 6 wird ein Permanentmagnet 7 mit geeigneter Polarisierung zur Erzeugung des Referenzmagnetfeldes befestigt.

Der Basisträger 6 wird mit einem weiterem keramischen Schaltungsträger - im Folgenden Treiberträger 9 genannt - über elektrische Verbindungskontakte 8 (Fig. 2 und 3) mit Hilfe einer der nach dem Stand der Technik verfügbaren Verbindungstechniken, vorzugsweise mittels Löttechnik, elektrisch verbunden.

Der entstandene Verbund aus einer oder mehreren **elektronischen Baugruppen** 5, Basisträger 6, Treiberträger 9, Permanentmagnet 7, elektrischen Verbindungskontakten 8 und Abstandskörper 10 wird in ein Gehäuse 11 (Fig.1 und 3) dichtend eingeklebt. Hierbei dient der Abstandskörper 10 als mechanische Anlage zur Erzielung ines minimalen mechanischen Abstandes zwischen **den** Oberseiten der kontaktierten elektronischen Bauteile 3 wie **magneto-resistive** Sensoren und der Oberseite des Gehäuses 11.

Die objektseitige Öffnung des Gehäuses 11 mit den auf dem Basisträger 6 freiliegenden **elektronische B**augruppen 5 wird mittels Verguss 12 planar bis zur Oberfläche des Gehäuses 11 aufgefüllt, so dass die Objektseite des Abstandskörpers 10 nicht vom Verguss 12 bedeckt wird und so den mechanischen Anschlag ders **magneto-resistiven** Sensor**baugruppe** 1 bildet.

Die Drahtbonds 13 liegen ausserhalb des Bereichs des Abstands zum bewegten Bauteil 2 und zwischen den Seitenflächen des senkrecht angeordneten **elektronischen Bauteils** 3 und der ersten Stirnseite 17 des **T**rägers 4.

Der Abstandskörper 10, der auf dem Basisträger 6 oder **T**räger 4 angeordnet ist, bildet sowohl einen Höhenanschlag für die Optimierung des Abstands zwischen der zum bewegten **B**auteil 2 weisenden Oberseite des **elektronischen Bauteils** 3 und der ebenfalls zum bewegten Bauteil 2 weisenden Oberseite des Gehäuses 11 als auch ein Mittel im Hinblick auf Montagetoleranzen.

### Gewerbliche Anwendbarkeit

Mit der Erfindung werden die kritischen Eigenschaften des analysierten Standes der Technik vermieden.

Dadurch, dass nach der erfindungsgemässen Lehre die Anordnung
- nicht nach herkömmlicher Planartechnik, aber entsprechend der vorgegebenen Richtung des Permanentmagnetfelds gefügt wird,
- mittels neuartiger Kombination von Mikromontagetechnologien den Aufbau, die Justierung und Montage auf einen Basisträger ermöglicht,
- die Anforderungen einer Temperaturbeständigkeit von ≤ 150° C bei kritischen Umgebungsbedingungen, wie Feuchte, Staub, Ölnebel, Vibrationen, Schockbelastungen erfüllt,
- verbesserte Effekte hinsichtlich der Messung auch bei Schockbelastungen und hohen Einsatztemperaturen bewirkt und
- insgesamt zur Erreichung hochempfindlicher Meßcharakteristiken geeignete Aufbau-und Montagetechnologien zur Fertigung des **zu kontaktierenden elektronischen Bauteils 3** schafft, wobei gerade dieses in seinem Aufbau und seinen Verbindungen einen extrem kleinen Abstand zum Meßobjekt aufweist, so dass allgemein sich bewegende und nicht nur rotierende Bauteile in ihrer Position mit einer extrem hohen Auflösung erfassbar werden,
sind in der Gesamtheit funktionell verschmelzende und überraschende Wirkungen vorhanden, mit denen die Erfindung eine effiziente Herstellungstechnologie ermöglicht und einen hohen Gebrauchswert in der industriellen Anwendung realisiert.

### Bezugszeichenliste

- 1 =: magneto-resistive Sensorbaugruppe
- 2 =: bewegtes Bauteil
- 3 =: kontaktieretes elektronisches Bauteil (Sensor, **magneto-resistiver** Sensor)
- 4 =: Träger, (Sensorträger)
- **5 =**: **eletronische Baugruppe**
- 6 =: Basisträger
- 7 =: Permanentmagnet
- 8 =: Verbindungskontakte
- 9 =: Treiberträger
- 10 =: Abstandskörper
- 11 =: Gehäuse
- 12 =: Verguss
- 13 =: Drahtbond
- 14 =: Drahtbondpads **als zweiter elektrischer Anschluss**
- 15 =: externer Anschluss **als dritter elektrischer Anschluss**
- 16 =: Anschlusspads **als erster elektrischer Anschluss**
- 17 =: **erste** Stirnseite des **T**rägers (4)
- 17.1 =: **zweite Stirnseite des Trägers (4)**
- 18 =: Dickschichtstruktur

## Patentansprüche

1. **Elektronische Baugruppe (5),** insbesondere Sensors**baugruppe (1),** vorzugsweise **magneto-**resistive Sensors**baugruppe (1)** für Positions- und Winkelmesssysteme, **aufweisend einen Träger (4), auf dem ein kontaktiertes elektronisches Bauteil (3)** mit ersten **elektrischen** Anschlüssen **angeordnet ist, sowie am Träger (4)** vorhandene **zweite und dritte** elektrische Anschlüssen **dadurch gekennzeichnet, dass**
a) das kontaktierte elektronische Bauteil (3) **mit einer Fläche des Trägers (4) verbunden ist und als erste elektrische Anschlüsse (16)** Anschlusspads (16) **auf einer senkrecht zu der Fläche des Trägers (4) stehenden Seite des elektronischen Bauteils (3)** aufweist,
b) eine **erste** Senkrecht zur erstgenannten Fläche des Trägers (4) liegende Stirnseite **(17)** des Trägers **(4)** in Dickschichttechnik strukturierte Kantenmetallisierungen aufweist die als Drahtbondpads **(14)** als zweite **elektrische Anschlüsse (14)** dienen,
c) die **erste** Stirnseite des Trägers **(4)** mittels Waferschnitttechnik kammartig gesägt ist,
d) die Drahtbondpads auf der **ersten** Stirnseite (17) des Trägers (4) übe Dickschichtstrukturen (18) mit externen Anschlüssen **an anderen Stirnseiten (17.1)** des Trägers (4) **als dritte elektrische Anschlüsse (15)** der elektronischen Baugruppe (5) elektrisch leitend verbunden sind und
e) die in einer Ebene zur Stirnseite des Trägers (4) **parallel versetzt** liegenden Anschlusspads (16) des elektronischen Bauteils (3) mittels Drahtbonds mit den Drahtbondpads (14) des Trägers (4) elektrisch verbunden sind.

2. **Elektronische Baugruppe** (5) nach Anspruch 1, **dadurch gekennzeichnet, dass** das elektronische Bauteil (3) als ein Sensor und die elektronische Baugruppe (5) als eine **magneto-resistive** Sensorbaugruppe (1) ausgebildet ist.

3. **Elektronische Baugruppe (5)** nach Anspruch 1 oder 2
**dadurch gekennzeichnet, dass**
**a) die eine inkrementale oder absolute Position eines bewegten Bauteiles (2) erfassende magneto-resistive** Sensorbaugruppe (1) einen Basisträger (6), einen Verguss (12), mindestens eine elektronische **Baugruppe (5),** und Drahtbonds (3) zwischen Sensor und Träger aufweist,
b) die Drahtbonds (13) ausserhalb des Bereichs des Abstands zum bewegten Bauteil (2) und zwischen den Seitenflächen des senkrecht angeordneten Sensors (3) und der **erste** Stirnseite (17) des Trägers **(4)** liegen,
c) ein auf dem Basisträger (6) oder Träger (4) angeordneter **Abstandskörper** (10) vorhanden ist, der sowohl einen Höhenanschlag für die Optimierung des Abstands zwischen der zum bewegten Bauteil (2) weisenden Oberseite des Sensors (3) und der ebenfalls zum bewegten Bauteil (2) weisenden Oberseite eines Gehäuses (11) als auch ein Mittel im Hinblick auf Montagetoleranzen darstellt und
**d)** auf der Rückseite des Basisträgers (6) ein Permanentmagnet (7) angeordnet ist.

4. **Elektronische Baugruppe** (5) einem der Ansprüche 1 bis 3, **dadurch gekenntzeichnet,** dass **das elektronische Bauteil** (3) auf den **T**räger (4) mittels Klebetechnik befestigt ist.

5. **Elektronische Baugruppe (5)** nach einem der Ansprüche 1 bis 4, **dadurch gekennzeichnet, dass** diese als diskretes Bauteil auf dem Basisträger mittels
- Klebetechnik,
- Leitkleberkontaktierung,
- Drahtbondverbindung oder
- Lottechnik
befestigt ist.

6. **Elektronische Baugruppe (5)** nach einem der Ansprüche 1 bis 5, **dadurch gekennzeichnet, dass** eine weitere **elektronische Baugruppe (5)** geometrisch definiert zur erstgenannten auf dem **Träger** (4) angeordnet ist.

7. **Elektronische Baugruppe** (5) nach einem der Ansprüche 1 bis 6, **dadurch gekennzeichnet, dass** ein Treiberträger (9), elektrisch verbunden über Verbindungskontakte (8) mit dem Basisträger (6), vorhanden ist.

## Claims

1. An electronic assembly (5), in particular a sensor assembly (1), preferably a magneto-resistive sensor assembly (1) for position and angle measuring systems, comprising a support (4) on which a contacted electronic component (3) with first electrical connections is disposed as well as second and third electrical connections provided on said support (4),
**characterised in that**
a) the contacted electronic component (3) is connected to one face of the support (4) and has connection pads (16) as first electrical connections (16) on a side of the electronic component (3) perpendicular to the face of the support (4),
b) a first front side (17) of the support (4) located perpendicularly to the first-mentioned surface of the support (4) has edge metallisations for wire bond pads structured in thick layer technology, which serve as second electrical connections (14),
c) the first front side of the support is sawn in a comb-like manner by means of wafer cutting technology,
d) the wire bond pads on the first front side of the support are connected in an electrically conducting manner to external connections on other front sides (17.1) of the support as third electrical connections of the electronic assembly and
e) the connection pads (16) of the electronic component lying in a parallel offset manner in a plane to the front side of the support are electrically connected by means of wire bonds to the wire bond pads of the support.

2. The electronic assembly (5) according to claim 1, **characterised in that** the electronic component (1) is a sensor and the electronic assembly (5) is a magneto-resistive sensor assembly (1).

3. The electronic assembly (5) according to claim 1 or 2,
**characterised in that**
a) the magneto-resistive sensor assembly (1) detecting an incremental or absolute position of a moving component comprises a base support, a casting, at least one electronic assembly and wire bonds between sensor and support,
b) the wire bonds (13) lie outside the area of the spacing from the moving component and between the side faces of the perpendicularly located sensor (3) and the first front side (17) of the support,
c) a spacer (10) located on the base support or support is provided, forming both a height stop for optimising the distance between the upper side of the sensor pointing towards the moving component and the upper side of a housing also pointing towards the moving component and also a means with respect to assembly tolerances and
d) a permanent magnet is arranged on the back of the base support.

4. The electronic assembly (5) according to one of claims 1 to 3, **characterised in that** the electronic component (3) is fixed on the support by means of adhesion technology.

5. The electronic assembly (5) according to one of claims 1 to 4, **characterised in that** this is secured as a discrete component on the base support by means of
- adhesion technology
- conductive adhesive contacting,
- wire bond connection or
- soldering technology.

6. The electronic assembly (5) according to one of claims 1 to 5, **characterised in that** another electronic assembly, geometrically defined with respect to the first-mentioned assembly, is disposed on the sensor support.

7. The electronic assembly (5) according to one of claims 1 to 6, **characterised in that** a driver support electrically connected to the base support via connecting contacts is provided.

## Revendications

1. Ensemble électronique (5), notamment ensemble de capteurs (1), de préférence ensemble de capteurs magnéto-résistifs (1) pour des système de mesure de la position et de mesure angulaire, comportant un support (4), sur lequel est disposé un premier composant électronique (3) mis en contact avec des premiers points de connexion électrique, ainsi que des deuxièmes et troisièmes points de connexion électrique présents sur le support (4), **caractérisé en ce que**
a) le composant électronique (3) mis en contact est relié avec une surface du support (4) et comporte en tant que premiers points de connexion électrique (16) des pastilles de connexion 16) sur une face du composant électrique (3) qui se trouve à la perpendiculaire de la surface du support (4),
b) une première face frontale (17) du support (4) se situant à la perpendiculaire de la première surface citée du support (4) comporte des métallisations de lisière structurées par technique de couche épaisse pour des pastilles de métallisation à fil, servant de deuxièmes points de connexion électrique (14),
c) la première face frontale du support est sciée en peigne au moyen d'une technique de coupe de tranches,
d) sur la première face frontale du support, les pastilles de métallisation à fil sont reliées par conduction d'électricité avec des points de connexion électrique externes sur d'autres faces frontales (17.1) du support, en tant que troisièmes points de connexion de l'ensemble électronique,
e) les pastilles de connexion (16) du composant électrique, situées dans un plan, avec un déport parallèle par rapport à la face frontale du support sont électriquement reliées par métallisation à fil avec les pastilles de métallisation à fil,

2. Ensemble électronique (5) selon la revendication 1, **caractérisé en ce que** le composant électronique (3) est un capteur et l'ensemble électronique (5) est un ensemble de capteurs magnéto-résistifs (1).

3. Ensemble électronique (5) selon la revendication 1 ou 2, **caractérisé en ce que**
a) le groupe de capteurs magnéto-résistifs détectant l'une des positions incrémentales ou absolues d'un composant déplacé (1) comporte un support de base, un scellement, au moins un ensemble électronique et des métallisations à fil entre le capteur et le support,
b) les métallisations à fil (13) se situent à l'extérieur de la zone d'écart par rapport au composant déplacé et entre les surfaces latérales du capteur (3) disposé à la perpendiculaire et la première face frontale (17) du support,
c) un élément d'écartement (10) disposé sur le support de base ou support, qui est aussi bien une butée en hauteur pour l'optimisation de l'écart entre la face supérieure du capteur dirigée vers le composant déplacé et la face supérieure également dirigée vers le composant déplacé d'un boîtier, qu'un moyen au niveau des tolérances est présent et
d) un aimant permanent est disposé sur la face arrière du support de base.

4. Ensemble électronique (5) selon l'une quelconque des revendications 1 à 3, **caractérisé en ce que** le composant électronique (3) est fixé sur le support par technique de collage.

5. Ensemble électronique (5) selon l'une quelconque des revendications 1 à 4, **caractérisé en ce qu'**il est fixé en tant que composant discret sur le support de base au moyen
- d'une technique de collage,
- d'un contact par adhésif conducteur,
- d'une liaison par métallisation à fil
- d'une technique de brasage.

6. Ensemble électronique (5) selon l'une quelconque des revendications 1 à 5, **caractérisé en ce qu'**un ensemble électronique supplémentaire est disposé de façon géométriquement définie au premier sur le support de capteur.

7. Ensemble électronique (5) selon l'une quelconque des revendications 1 à 6, **caractérisé en ce qu'**un support d'excitateur est électriquement relié, via des contacts de liaison avec le support de base.
